# EUROPÄISCHE PATENTSCHRIFT

(11) **EP 2 251 396 B1**
(45) Veröffentlichungstag und Bekanntmachung des Hinweises auf die Patenterteilung: **19.11.2014**
(21) Anmeldenummer: 10008202.3
(22) Anmeldetag: 07.07.2004
(51) Int. Cl.: C09K 11/06, H01L 51/00

(54) **Zur Emission befähigte organische Verbindungen und Elektronikbauteile diese enthaltend**
Organic emission-capable materials and electronic components containing same
Matriaux organiques destinés à l'émission et composants électroniques en étant pourvus

(30) Priorität: 07.07.2003 DE 10330761; 25.11.2003 DE 10355380
(43) Veröffentlichungstag der Anmeldung: 17.11.2010
(62) Teilanmeldung aus: 04740735.8
(73) Patentinhaber: Merck Patent GmbH, 64293 Darmstadt (DE)
(72) Erfinder: Stoessel, Philipp, 60487 Frankfurt am Main (DE); Gerhard, Anja, 63329 Egelsbach (DE); Vestweber, Horst, 34630 Gilserberg-Winterscheid (DE); Becker, Heinrich, 65719 Hofheim (DE)

(56) Entgegenhaltungen:
- EP-A2- 0 676 461
- WO-A2-97/20877
- US-A1- 2002 055 013
- US-A1- 2002 132 911

## Beschreibung

Die vorliegende Erfindung beschreibt die Verwendung neuer Materialien in organischen elektronischen Bauteilen wie Elektrolumineszenzelementen und deren Verwendung in darauf basierenden Displays.

In einer Reihe von verschiedenartigen Anwendungen, die im weitesten Sinne der Elektronikindustrie zugerechnet werden können, ist der Einsatz organischer Halbleiter als Wirkkomponenten (= Funktionsmaterialien) seit geraumer Zeit Realität bzw. wird in naher Zukunft erwartet.

So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten.

Der Einsatz spezieller halbleitender organischer Verbindungen, die zum Teil auch zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die Organischen-Lichtemittierenden-Dioden (OLEDs), besitzen ein sehr breites Anwendungsspektrum als:
1. weiße oder farbige Hinterleuchtungen für monochrome oder mehrfarbige Anzeigeelemente (wie z. B. im Taschenrechner, für Mobiltelefone und andere tragbare Anwendungen),
2. großflächige Anzeigen (wie z. B. Verkehrsschilder, Plakate und andere Anwendungen),
3. Beleuchtungselemente in allen Farben und Formen,
4. monochrome oder vollfarbige Passiv-Matrix-Displays für tragbare Anwendungen (wie z. B. Mobiltelefone, PDAs, Camcorder und andere Anwendungen),
5. vollfarbige großflächige hochauflösende Aktiv-Matrix-Displays für verschiedenste Anwendungen (wie z. B. Mobiltelefone, PDAs, Laptops, Fernseher und andere Anwendungen).

Bei diesen Anwendungen ist die Entwicklung teilweise bereits sehr weit fortgeschritten; dennoch besteht immer noch großer Bedarf an technischen Verbesserungen.

Für einfachere OLEDs enthaltende Vorrichtungen ist die Markteinführung bereits erfolgt, wie die Auto-Radios der Firma Pioneer oder eine Digitalkamera der Firma Kodak mit "Organischem Display" belegen. Allerdings gibt es immer noch erhebliche Probleme, die einer dringenden Verbesserung bedürfen:
1. So ist v. a. die operative Lebensdauer von OLEDs immer noch gering, so daß bis dato nur einfache Anwendungen kommerziell realisiert werden können.
2. Die Effizienzen von OLEDs sind zwar akzeptabel, aber auch hier sind natürlich - gerade für tragbare Anwendungen ("portable applications") - immer noch Verbesserungen erwünscht.
3. Die Alterungsprozesse gehen i. d. R. mit einem Anstieg der Spannung einher. Dieser Effekt macht spannungsgetriebene organische Elektrolumineszenzvorrichtungen, z. B. Displays oder Anzeige-Elemente, schwierig bzw. unmöglich. Eine stromgetriebene Ansteuerung ist aber gerade in diesem Fall aufwendiger und teurer.
4. Die benötigte Betriebsspannung ist gerade bei effizienten phosphoreszierenden OLEDs recht hoch und muß daher verringert werden, um die Leistungseffizienz zu verbessern. Das ist gerade für tragbare Anwendungen von großer Bedeutung.
5. Der benötigte Betriebsstrom ist ebenfalls in den letzten Jahren verringert worden, muß aber noch weiter verringert werden, um die Leistungseffizienz zu verbessern. Das ist gerade für tragbare Anwendungen besonders wichtig.
6. Durch die Vielfalt an Schichten ist der Aufbau der OLEDs komplex und technologisch sehr aufwendig. Daher wäre es wünschenswert, OLEDs mit einem einfacheren Schichtaufbau, der weniger Schichten benötigt, mit weiterhin guten Eigenschaften realisieren zu können.

Die oben unter 1. bis 7. genannten Gründe machen Verbesserungen bei der Herstellung von OLEDs notwendig.

Eine Entwicklung hierzu, die sich in den letzten Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, 1999, 75, 4-6]. Aus quantenmechanischen Gründen ist unter Verwendung metallorganischer Verbindungen eine bis zu vierfache Quanten-, Energie- und Leistungseffizienz möglich. Ob sich diese neue Entwicklung durchsetzen wird, hängt zum einen stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für die praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Dokument US 2002/132911 A1 offenbart halogenfreies 9,9'-Spirobifluoren der Formel (II), wobei R₁ unter anderem auch für -SO₂-N(C₁-C₁₈-Alkyl)₂ steht und diese Verbindung als Monomer für die kationisch-oxidative Polymerisation eingesetzt wird.

Der allgemeine Aufbau von organischen Elektrolumineszenzvorrichtungen ist beispielsweise in US 4,539,507 und US 5,151,629 sowie EP 01202358 beschrieben.

Üblicherweise besteht eine organische Elektrolumineszenzvorrichtung aus mehreren Schichten, die mittels Vakuummethoden oder unterschiedlicher Druckmethoden aufeinander aufgebracht werden. Diese Schichten sind im einzelnen:
1. Eine Trägerplatte = Substrat (üblicherweise Glas oder Kunststoffolien).
2. Eine transparente Anode (üblicherweise Indium-Zinn-Oxid, ITO).
3. Eine Lochinjektions-Schicht (**H**ole **I**njection **L**ayer = HIL): z. B. auf der Basis von Kupferphthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole **T**ransport **L**ayer = HTL): üblicherweise auf der Basis von Triarylamin-Derivaten, z. B. 4,4',4"-Tris(N-1-naphthyl-N-phenyl-amino)-triphenylamin (NaphDATA) als erste Schicht und N,N'-Di(naphth-1-yl)-N,N'-diphenyl-benzidin (NPB) als zweite Lochtransportschicht.
5. Eine oder mehrere Emissions-Schichten (**Em**ission **L**ayer = EML): diese Schicht (bzw. Schichten) kann teilweise mit den Schichten 4 bis 8 zusammenfallen, besteht aber üblicherweise aus mit Fluoreszenzfarbstoffen, z. B. N,N'-Diphenyl-chinacridon (QA), oder Phosphoreszenzfarbstoffen, z. B. Tris(phenylpyridyl)-iridium (Ir(PPy)₃) oder Tris(2-benzothiophenyl-pyridyl)-iridium (Ir(BTP)₃), dotierten Matrixmaterialien, wie 4,4'-Bis(carbazol-9-yl)-biphenyl (CBP). Die Emissionsschicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockier-Schicht (Hole-Blocking-Layer = HBL): diese Schicht kann teilweise mit den Schichten 7 und 8 zusammenfallen. Sie besteht üblicherweise aus BCP (2,9-Dimethyl-4,7-diphenyl-1,10-phenanthrolin = Bathocuproin) oder Bis-(2-methyl-8-chinolinolato)-4-(phenylphenolato)-aluminium(III) (BAIq).
7. Eine Elektronentransport-Schicht (**E**lectron **T**ransport **L**ayer = ETL): meist auf Basis von Aluminium-tris-8-hydroxychinolinat (AlQ₃).
8. Eine Elektroneninjektions-Schicht (**E**lectron **I**njection **L**ayer = EIL): diese Schicht kann teilweise mit Schicht 4, 5, 6 und 7 zusammenfallen, bzw. es wird ein kleiner Teil der Kathode speziell behandelt bzw. speziell abgeschieden.
9. Eine weitere Elektroneninjektions-Schicht (**E**lectron **I**njection **L**ayer = EIL): ein dünne Schicht bestehend aus einem Material mit einer hohen Dielektrizitätskonstanten, wie z. B. LiF, Li₂O, BaF₂, MgO, NaF.
10. Eine Kathode: hier werden in der Regel Metalle, Metallkombinationen oder Metallegierungen mit niedriger Austrittsarbeit verwendet, so z. B. Ca, Ba, Cs, Mg, Al, In, Mg/Ag.

Diese ganze Vorrichtung wird entsprechend (je nach Anwendung) strukturiert, kontaktiert und schließlich auch hermetisch versiegelt, da sich i. d. R. die Lebensdauer derartiger Vorrichtungen bei Anwesenheit von Wasser und/oder Luft drastisch verkürzt. Das Gleiche gilt auch für sogenannte invertierte Strukturen, bei denen das Licht aus der Kathode ausgekoppelt wird. Bei diesen invertierten OLEDs besteht die Anode z. B aus Al/Ni/NiOx oder Al/Pt/PtOx oder anderen Metall/Metalloxid-Kombinationen, die ein HOMO größer 5 eV besitzen. Die Kathode besteht dabei aus den gleichen Materialien, die in Punkt 9 und 10 beschrieben sind, mit dem Unterschied, daß das Metall, wie z. B. Ca, Ba, Mg, Al, In usw., sehr dünn und damit transparent ist. Die Schichtdicke liegt unter 50 nm, besser unter 30 nm, noch besser unter 10 nm. Auf diese transparente Kathode kann noch ein weiteres transparentes Material aufgebracht werden, z. B. ITO (Indium-Zinn-Oxid), IZO (Indium-ZinkOxid) usw..

Organische Elektrolumineszenzvorrichtungen, bei denen die Emissionsschicht (EML) aus mehr als einer Substanz besteht, sind schon seit längerem bekannt.

Im oben genannten Aufbau kommt dem Matrixmaterial der Emissions-Schicht (EML) eine besondere Rolle zu. Das Matrixmaterial muß den Ladungstransport von Löchern und/oder Elektronen ermöglichen oder verbessern und/oder die Ladungsträgerrekombination ermöglichen oder verbessern und gegebenenfalls die bei der Rekombination entstehende Energie auf den Emitter übertragen.

Diese Aufgabe wird bei den Elektrolumineszenzvorrichtungen auf Basis phosphoreszierender Emitter bislang von Matrixmaterialien, die Carbazol-Einheiten enthalten, übernommen.

Matrixmaterialien, die Carbazol-Einheiten, wie z. B. das häufig verwendete CBP, enthalten, haben in der Praxis jedoch einige Nachteile. Diese sind unter anderem in der oftmals kurzen bis sehr kurzen Lebensdauer der mit ihnen hergestellten Devices und den häufig hohen Betriebsspannungen, die zu geringen Leistungseffizienzen führen, zu sehen. Des weiteren hat sich gezeigt, daß aus energetischen Gründen CBP für blau emittierende Elektrolumineszenzvorrichtungen ungeeignet ist, was in einer schlechten Effizienz resultiert. Außerdem ist der Aufbau der Devices sehr komplex, wenn CBP als Matrixmaterial verwendet wird, da zusätzlich eine Lochblockierschicht und eine Elektronentransportschicht verwendet werden müssen. Werden diese zusätzlichen Schichten nicht verwendet, wie z. B. von Adachi et al. (Organic Electronics 2001, 2, 37) beschrieben, so beobachtet man zwar gute Effizienzen, aber nur bei extrem geringen Helligkeiten, während die Effizienz bei höherer Helligkeit, wie sie für die Anwendung nötig ist, um mehr als eine Größenordnung geringer ist. So werden für hohe Helligkeit hohe Spannungen benötigt, so daß hier die Leistungseffizienz sehr niedrig ist, was insbesondere für Passiv-Matrix-Anwendungen ungeeignet ist.

Es wurde nun überraschend gefunden, daß die Verwendung bestimmter Matrixmaterialien in Kombination mit bestimmten Emittern zu deutlichen Verbesserungen gegenüber dem Stand der Technik, insbesondere in Bezug auf die Effizienz und in Kombination mit einer stark erhöhten Lebensdauer, führen. Zudem ist mit diesen Matrixmaterialien ein deutlich vereinfachter Schichtaufbau der OLED möglich, da weder eine separate Lochblockierschicht, noch eine separate Elektronentransport- und/oder Elektroneninjektionsschicht verwendet werden muß.

Der Gegenstand der Erfindung ist definiert gemäß Anspruch 1, mit Verbindungen gemäß Formel (40), (41a), (42), (43), (44a), (45), (46), (47a) und (48),

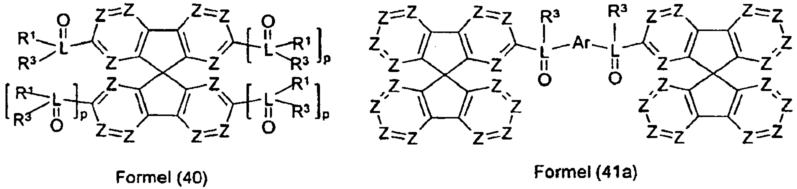

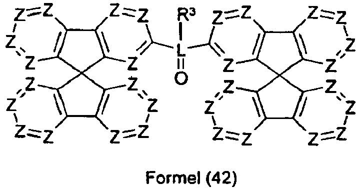

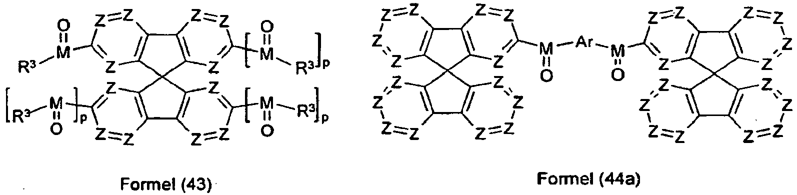

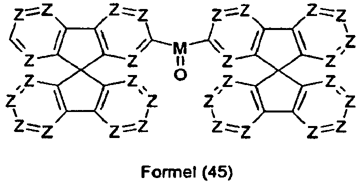

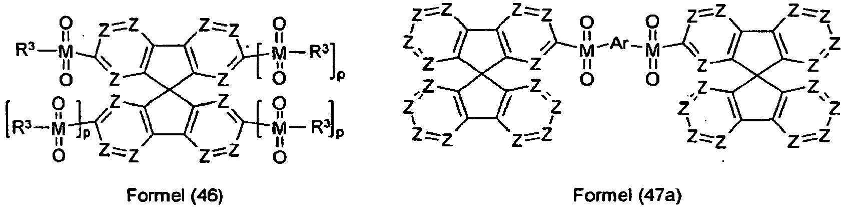

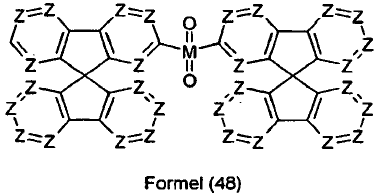

Die vorliegende Erfindung wird durch die folgenden Beispiele für Matrixmaterialien A näher erläutert, ohne sie darauf einschränken zu wollen. Der Fachmann kann aus der Beschreibung und den aufgeführten Beispielen ohne erfinderisches Zutun weitere erfindungsgemäße Matrixmaterialien herstellen.

| | | |
|---|---|---|
| 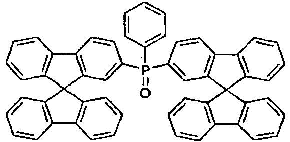 | 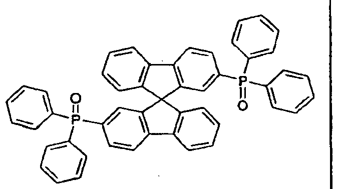 | 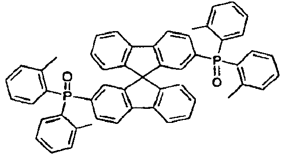 |
| Beispiel 1 | Beispiel 2 | Beispiel 3 |
| 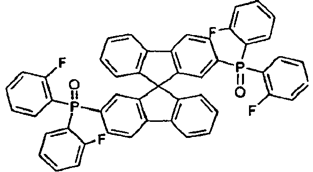 | 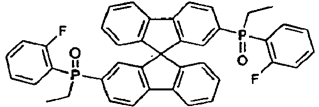 | 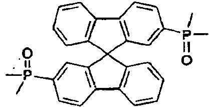 |
| Beispiel 4 | Beispiel 5 | Beispiel 6 |
| 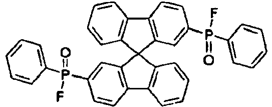 | | |
| 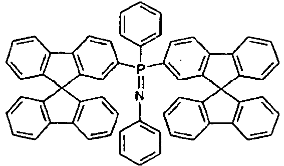 | 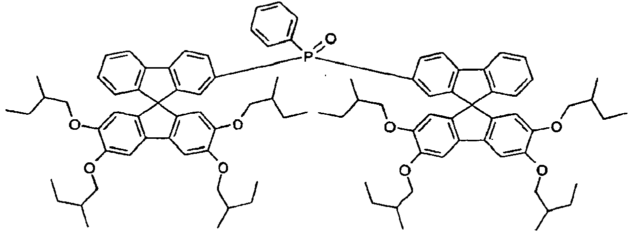 | |
| Beispiel 13 | Beispiel 14 | |
| 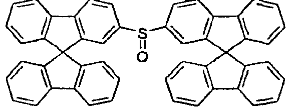 | 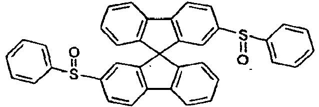 | 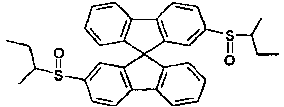 |
| Beispiel 44 | Beispiel 45 | Beispiel 46 |
| 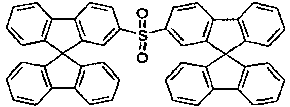 | 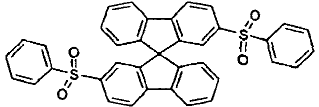 | 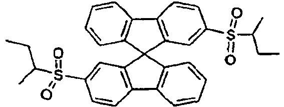 |
| Beispiel 47 | Beispiel 48 | Beispiel 49 |

Weiterhin können die erfindungsgemäßen Matrixmaterialien A auch durch die beispielsweise o. g. Reaktionstypen weiter funktionalisiert werden und so zu *erweiterten Matrixmaterialien A* umgesetzt werden. Hier ist als Beispiel die Funktionalisierung mit Arylboronsäuren gemäß SUZUKI oder mit Aminen gemäß HARTWIG-BUCHWALD zu nennen.

Um als Funktionsmaterial Verwendung zu finden, werden die erfindungsgemäßen Matrixmaterialien A oder deren Mischungen, gegebenenfalls zusammen mit den Emittern B, nach allgemein bekannten, dem Fachmann geläufigen Methoden, wie Vakuumverdampfung, Verdampfen im Trägergasstrom oder auch aus Lösung durch Spincoaten oder mit verschiedenen Druckverfahren (z. B. Tintenstrahldrucken, Off-set-Drucken, LITI-Druck, etc.), in Form eines Films auf ein Substrat aufgebracht.

Dabei kann die Verwendung von Druckverfahren Vorteile hinsichtlich der Skalierbarkeit der Fertigung, als auch bezüglich der Einstellung von Mischungsverhältnissen in verwendeten Blend-Schichten haben.

Die oben beschriebenen Matrixmaterialien werden in Kombination mit Phosphoreszenz-Emittern verwendet. Die so dargestellten organischen Elektrolumineszenzvorrichtungen zeichnen sich dadurch aus, daß sie als Emitter B mindestens eine Verbindung enthalten, die dadurch gekennzeichnet ist, daß sie bei geeigneter Anregung Licht, vorzugsweise im sichtbaren Bereich, emittiert und außerdem mindestens ein Atom der Ordungszahl größer 20, bevorzugt größer 38 und kleiner 84, besonders bevorzugt größer 56 und kleiner 80 enthält.

Bevorzugt werden als Phosphoreszenz-Emitter in den oben beschriebenen organischen Elektroluminesenzvorrichtungen Verbindungen, die Molybdän, Wolfram, Rhenium, Ruthenium, Osmium, Rhodium, Iridium, Palladium, Platin, Silber, Gold oder Europium enthalten, verwendet.

Besonders bevorzugte Mischungen enthalten als Emitter B mindestens eine Verbindung der Formel (49) bis (52), 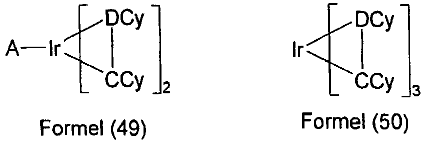 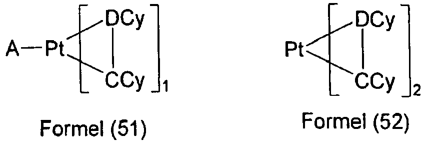 wobei für die verwendeten Symbole gilt:
- DCy: ist gleich oder verschieden bei jedem Auftreten eine cyclische Gruppe, die mindestens ein Donoratom, bevorzugt Stickstoff oder Phosphor, enthält, über welches die cyclische Gruppe an das Metall gebunden ist, und die wiederum einen oder mehrere Substituenten R¹¹ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹¹ tragen kann;
- R¹¹: ist gleich oder verschieden bei jedem Auftreten H, F, Cl, Br, I, NO₂, CN, eine geradkettige, verzweigte oder cyclische Alkyl- oder Alkoxygruppe mit 1 bis 40 C-Atomen, wobei ein oder mehrere nicht benachbarte CH₂-Gruppen durch C=O, C=S, C=Se, C=NR⁴, -O-, -S-, -NR⁵- oder -CONR⁶- ersetzt sein können und wobei ein oder mehrere H-Atome durch F ersetzt sein können, oder ein aromatisches oder heteroaromatisches Ringsystem mit 4 bis 14 C-Atomen, das durch einen oder mehrere, nicht-aromatische Reste R¹¹ substituiert sein kann, wobei mehrere Substituenten R¹¹, sowohl am selben Ring als auch an den beiden unterschiedlichen Ringen zusammen wiederum ein weiteres mono- oder polycyclisches Ringsystem aufspannen können;
- A: ist gleich oder verschieden bei jedem Auftreten ein zweizähnig chelatisierender Ligand, bevorzugt ein Di-ketonat-ligand;
- R⁴, R⁵, R⁶: ist gleich oder verschieden bei jedem Auftreten H oder ein aliphatischer oder aromatischer Kohlenwasserstoffrest mit 1 bis 20 C-Atomen.

Beispiele der oben beschriebenen Emitter können zum Beispiel den Anmeldungen WO 00170655, WO 01141512, WO 02/02714, WO 02/15645, EP 1191613, EP 1191612 und EP 1191614 entnommen werden.

Die Mischung enthält zwischen 1 und 99 Gew.%, vorzugsweise zwischen 3 und 95 Gew.%, besonders bevorzugt zwischen 5 und 50 Gew.%, insbesondere zwischen 7 und 20 Gew.% Emitter B bezogen auf die Gesamtmischung aus Emitter B und Matrixmaterial A.

Weiterer Gegenstand der vorliegenden Erfindung sind elektronische Bauteile, insbesondere organische Elektrolumineszenzvorrichtungen (OLED), organische Solarzellen (O-SCs), organische Feldeffekttransistoren (O-FETs), organische optische Detektoren, organische Photorezeptoren in der Elektrophotographie oder auch organische Laserdioden (O-Laser) enthaltend die erfindungsgemäße Verbindung gemäß Anspruch 1.

Die organische Elektrolumineszenzvorrichtung kann außer der Kathode, der Anode und der Emitterschicht weitere Schichten enthalten, wie z. B. Lochinjektionsschicht, Lochtransportschicht, Lochblockierschicht, Elektronentransportschicht und/oder Elektroneninjektionsschicht. Es sei aber an dieser Stelle darauf hingewiesen, daß nicht notwendigerweise jede dieser Schichten vorhanden sein muß. So hat sich beispielsweise gezeigt, daß eine OLED, die weder eine separate Lochblockierschicht, noch eine separate Elektronentransportschicht enthält, weiterhin sehr gute Ergebnisse in der Elektrolumineszenz zeigt, insbesondere eine nochmals deutlich höhere Leistungseffizienz.

Dies ist besonders überraschend, da eine entsprechende OLED mit einem Carbazolhaltigen Matrixmaterial ohne Lochblockier- und Elektronentransportschicht nur sehr geringe Leistungseffizienzen zeigt, insbesondere bei hoher Helligkeit (vgl. Adachi et al., Organic Electronics 2001, 2, 37).

Im vorliegenden Anmeldetext und auch in den im weiteren folgenden Beispielen wird nur auf organische Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße Schichten aus den erfindungsgemäßen Mischungen herzustellen und anzuwenden, insbesondere in OLED-nahen oder verwandten Anwendungen.

Die nachfolgend beschriebenen Beispiele zeigen klar auf, daß die erfindungsgemäßen Matrixmaterialien A zu einer deutlichen Verbesserung der Effizienz und der Lebendauer der mit diesen hergestellten Elektrolumineszenzvorrichtungen führen. Außerdem gelingt es bei Verwendung der Matrixmaterialien A, blau emittierende Elektrolumineszenzvorrichtungen herzustellen.

### Beispiele:

### Allgemeines Meßverfahren zur Bestimmung der Glasübungstemperatur:

Die sublimierten Proben wurden zunächst mit einer Heizrate von 10 K/min. ausgehend von 25 °C bis zum Schmelzpunkt der Substanz +50 K aufgeheizt. Anschließend wurden sie von dieser Temperatur mit einer Heizrate von 80 K/min auf 25 °C abgekühlt. Die Messung der Glasübergangstemperatur T_{g} erfolgte durch erneutes Aufheizen mit einer Heizrate von 10 K/min bis zu einer Temperatur 50 K oberhalb des Schmelzpunktes der Substanz mit einem Gerät der Fa. Netzsch DCS 204 (TASC 414/4 Controler und CC200 C Controler).

### 1. Synthese von Matrixmaterialien

Die nachfolgenden Synthesen wurden - sofern nicht anders angegeben - unter einer Schutzgasatmosphäre in getrockneten Lösemitteln durchgeführt. Die Edukte wurden von ALDRICH [Dichlorphenylphosphin] bezogen. 2-Brom-9,9'-spirobifluoren wurde nach Literaturmethoden (Pei, Jian et al., J. Org. Chem., 2002, 67(14), 4924-4936) dargestellt.

### Beispiel 1: Bis(9,9'-spiro-bifluoren-2-yl)phenylphosphinoxid (Matrixmaterial M1)

Aus einer Lösung von 98.8 g (250 mmol) 2-Brom-9,9'-spirobifluoren und 6 ml 1,2-Dichlorethan in 1000 ml THF und 7.1 g (290 mmol) Magnesium wurde in der Siedehitze das entsprechende Grignard-Reagens hergestellt. Zu dieser Grignard-Lösung wurde bei 0-5 °C eine Lösung von 16.3 ml (120 mmol) Dichlorphenylphosphin in 100 ml THF während 15 min. zugetropft. Anschließend wurde die Mischung 1 h unter Rückfluß erhitzt. Nach Abkühlen wurde die Mischung mit 10 ml Wasser versetzt und bis zur Trockene eingeengt. Der farblose Rückstand wurde in 1000 ml Dichlormethan aufgenommen, die Suspension wurde dreimal mit 300 ml Wasser gewaschen. Die organische Phase wurde abgetrennt, über Natriumsulfat getrocknet und anschließend eingeengt. Der farblose Rückstand wurde in 1000 ml Essigsäureethylester gelöst und tropfenweise unter gutem Rühren mit einem Gemisch aus 10.3 ml Wasserstoffperoxid (35 Gew.% in Wasser) und 100 ml Wasser versetzt. Nach 18 h Rühren wurde der ausgefallene farblose Feststoff abgesaugt, mit Ethanol gewaschen und getrocknet. Der Feststoff wurde dreimal aus Chlorbenzol (10 ml/g) umkristallisiert und anschließend im Hochvakuum (T = 385 °C, p = 5 x 10⁻⁵ mbar) sublimiert. Die Ausbeute bei einer Reinheit > 99.9 % nach HPLC betrug 40.1 g (53 mmol), entsprechend 42.4 % der Th.
Schmelzpunkt: Tₘ = 334 °C , Glasübergangspunkt: T_{g} = 161 °C. ³¹P-NMR (CDCl₃): □ [ppm] = 30.4 (s). ¹H-NMR (CDCl₃): □ [ppm] = 7.83 - 7.81 (m, 2 H), 7.76 - 7.75 (m, 6 H), 7.38 - 7.22 (m, 15 H), 7.15 - 7.12 (m, 2 H), 7.06 - 7.03 (m, 4 H), 6.72 - 6.71 (m, 2 H), 6.64 - 6.60 (m, 4 H).

### Beispiel 2: Bis(9,9'-spirobifluoren-2-yl)sulfoxid (Matrixmaterial M2)

Zu einer auf -78 °C gekühlten Suspension von 98.8 g (250 mmol) 2-Brom-9,9'-spirobifluoren in 1500 ml THF wurden 110 ml (275 mmol) einer n-Butyllithium-Lösung (2.5 M in Hexan) so zugetropft, daß die Temperatur nicht über -65 °C anstieg. Die Reaktionsmischung wurde 3 h bei -78 °C gerührt und dann mit einem Gemisch aus 7.2 ml (125 mmol) Thionylchlorid und 300 ml THF tropfenweise versetzt und anschließend noch weitere 3 h bei -78 °C nachgerührt. Nach Erwärmen der Reaktionsmischung auf Raumtemperatur wurde das Reaktionsgemisch mit 25 ml Wasser versetzt und im Vakuum zur Trockene eingeengt. Der Rückstand wurde in 1000 ml Dioxan und 500 ml Wasser aufgenommen, die organische Phase wurde abgetrennt, nochmals mit 500 ml Wasser gewaschen und anschließend über Magnesiumsulfat getrocknet. Anschließend wurde der nach Einengen der organischen Phase verbliebene Feststoff fünfmal aus Dioxan (1 g/ml) umkristallisiert und dann im Hochvakuum (T = 370 °C, p = 5 x 10⁻⁵ mbar) sublimiert. Die Ausbeute bei einer Reinheit > 99.9 % nach HPLC betrug 114.0 g (168 mmol), entsprechend 67.2 % der Th..
Schmelzpunkt: Tₘ = 365 °C, Glasübergangspunkt: T_{g} = 178 °C.
¹H-NMR (CDCl₃): □ [ppm] = 7.83 (m, 4H), 7.75 (m, 2H), 7.73 (m, 2H), 7.37-7.29
(br. m, 8H), 7.09-7.03 (br. m, 6H), 6.86 (m, 2H), 6.70 (m, 4H), 6.65 (m, 2H).

### Beispiel 3 (Vergleichsbeispiel) 1,1'-Binaphthyl-2,2'-bis(diphenylphosphinoxid) (Matrixmaterial M3)

Die Synthese wurde durch Oxidation von racemischem 1,1'-Binaphthyl-2,2'-bis(diphenylphosphin) (erhalten von Aldrich) mit Wasserstoffperoxid in Analogie zu Beispiel 1 durchgeführt.

Die Matrixmaterialien **M1** bis **M3** sind der Übersichtlichkeit halber im folgenden nochmals abgebildet:

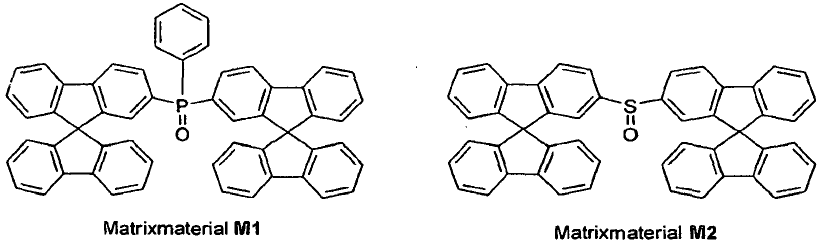

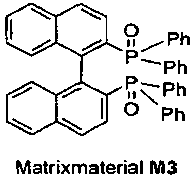

### 2. Herstellung und Charakterisierung von organischen Elektrolumineszenzvorrichtungen, die erfindungsgemäße Verbindungen enthalten

Die Herstellung von OLEDs erfolgte nach dem im folgenden skizzierten allgemeinen Verfahren. Dieses mußte natürlich im Einzelfall auf die jeweiligen Gegebenheiten (z. B. Schichtdickenvariation, um optimale Effizienz bzw. Farbe zu erreichen) angepaßt werden. Erfindungsgemäße Elektrolumineszenzvorrichtungen können beispielsweise wie in der nicht offengelegten Anmeldung DE 10317556.3 beschrieben, dargestellt werden.

### 3. Device-Beispiele

In diesen Beispielen werden die Ergebnisse verschiedener OLEDs gegenübergestellt. Der grundlegende Aufbau, die verwendeten Materialien, der Dotierungsgrad und die Schichtdicken war für die Beispielexperimente zur besseren Vergleichbarkeit identisch. Es wurde lediglich das Wirtsmaterial in der Emitterschicht getauscht.

Das erste Beispiel beschreibt einen Vergleichsstandard gemäß dem Stand der Technik, bei dem die Emitterschicht aus dem Wirtsmaterial CBP und dem Gastmaterial Ir(PPy)₃ besteht. Des weiteren wird eine OLED mit einer Emitterschicht bestehend aus dem Wirtsmaterial Bis(9,9'-spirobifluoren-2-yl)phenylphosphinoxid (Synthese s. Beispiel 1) und dem Gastmaterial Ir(PPy)₃ (synthetisiert nach WO 02/060910) beschrieben, ebenso wie OLEDs mit weiteren erfindungsgemäßen Wirtsmaterialien. Es wurden OLEDs mit folgendem Aufbau erzeugt:

| | |
|---|---|
| PEDOT | 60 nm (aus Wasser aufgeschleudert; PEDOT bezogen von H. C. Starck; Poly[3,4-ethylendioxy-2,5-thiophen]) |
| NaphDATA | 20 nm (aufgedampft; NaphDATA bezogen von SynTec; 4,4',4"-Tris(N-1-naphthyl-N-phenyl-amino)-triphenylamin |
| S-TAD | 20 nm (aufgedampft; S-TAD hergestellt nach WO99/12888; 2,2',7,7'-Tetrakis(diphenylamino)-spirobifluoren) |
| Emitter-Schicht: CPB | 20 nm (aufgedampft; CPB bezogen von ALDRICH und weiter gereinigt, schließlich noch zweimal sublimiert; 4,4'-Bis-(N-carbazolyl)biphenyl) Vergleichsstandard) |
| Bis(9,9'-spiro-bifluoren-2-yl)-phenylphosphinoxid | 20 nm (aufgedampft; synthetisiert und gereinigt nach Beispiel 1) |
| ODER: | |
| Bis(9,9'-spirobifluoren-2-yl)-sulfoxid | 20 nm (aufgedampft; synthetisiert und gereinigt nach Beispiel 2) |
| ODER: | |
| 1,1'-Binaphthyl-2,2'-bis(diphenyl-phosphinoxid) | 20 nm (aufgedampft; synthetisiert und gereinigt nach Beispiel 3); jeweils dotiert mit 15 %Triplett-Emitter: |
| Ir(PPy)₃ | (aufgedampft; synthetisiert nach WO 02/060910) |
| BCP | 10 nm (aufgedampft; BCP bezogen von ABCR, verwendet wie erhalten; 2,9-Dimethyl-4,7-diphenyl-1,10-phenanthrolin); nicht in allen Beispielen verwendet; |
| AIQ₃ | 10 nm (aufgedampft: AIQ₃ bezogen von SynTec; Tris(chinolinolato)aluminium(III)); nicht in allen Beispielen verwendet |
| Ba-Al | 3 nm Ba, darauf 150 nm Al als Kathode. |

Diese noch nicht optimierten OLEDs wurden standardmäßig charakterisiert; hierfür wurden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt.

### Elektrolumineszenzspektren:

Die OLEDs, sowohl der Vergleichsstandard (OLED mit CBP), als auch die OLEDs mit Bis(9,9'-spirobifluoren-2-yl)phenylphosphinoxid, mit Bis(9,9'-spirobifluoren-2-yl)sulfoxid und mit 1,1'-Binaphthyl-2,2'-bis(diphenylphosphinoxid) als Wirtsmaterial zeigen grüne Emission, resultierend aus dem Dotanden Ir(PPy)₃.

### Effizienz als Funktion der Helligkeit:

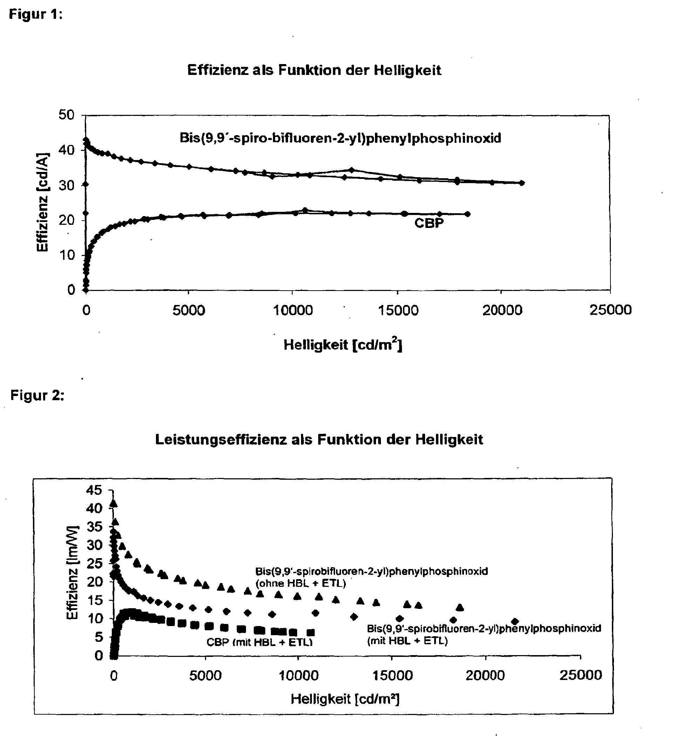

Für OLEDs hergestellt mit dem Wirtsmaterial CBP (Tabelle 1, Beispiel 1) erhält man, unter den oben beschriebenen Bedingungen, typischerweise eine Effizienz von etwa 20 bis 25 cd/A, und für die Referenzleuchtdichte von 100 cd/m² werden 4.8 V benötigt. Im Gegensatz dazu zeigen OLEDs hergestellt mit dem Wirtsmaterial Bis(9,9'-spirobifluoren-2-yl)phenylphosphinoxid eine maximale Effizienz von über 40 cd/A, wobei die benötigte Spannung für die Referenzleuchtdichte von 100 cd/m² sogar auf 4.0 V gesenkt wird (Fig.1 und Tabelle 1, Beispiel 2a).

Insbesondere wenn weder eine Lochblockierschicht (HBL), noch eine Elektronentransportschicht (ETL) verwendet werden, wenn also die dotierte Matrix (EML) an die Kathode bzw. die Elektroneninjektionsschicht grenzt, werden besonders hohe Leistungseffizienzen (gemessen in Im/W) erreicht, wie in Fig. 2 abgebildet (siehe auch Tabelle 1, Beispiel 2a). So wird beim Vergleichsstandard (unter Verwendung von BCP als Lochblockierschicht und AIQ₃ als Elektronentransportschicht) eine maximale Leistungseffizienz von 12 lm/W erreicht. Mit Bis(9,9'-spirobifluoren-2-yl)phenylphosphinoxid wird, ebenfalls unter Verwendung von BCP und AIQ₃, eine maximale Leistungseffizienz von 34 lm/W erreicht, während ohne Verwendung von BCP und AIQ₃, d. h. wenn die dotierte Matrix (EML) direkt an die Kathode angrenzt, eine maximale Leistungseffizienz von 42 lm/W erreicht wird (Tabelle 1, Beispiel 2b). Bei einer Helligkeit von 100 cd/m² ist die Leistungseffizienz immer noch 16 lm/W (mit Verwendung einer HBL und einer ETL) und 25 lm/W, wenn die dotierte Matrix (EML) direkt an die Kathode angrenzt. Weitere OLEDs mit Bis(9,9'-spirobifluoren-2-yl)sulfoxid (Beispiel 3a und 3b) und 1,1'-Binaphthyl-2,2'-bis(diphenylphosphinoxid) (Beispiel 4a und 4b) und als Wirtsmaterial zeigen sowohl mit HBL und ETL als auch ohne HBL und ETL eine verbesserte Effizienz im Vergleich zu OLEDs mit CBP (Beispiel 1) als Wirtsmaterial. Alle Beispiele sind in Tabelle 1 zusammengefaßt.

### Lebensdauervergleich:

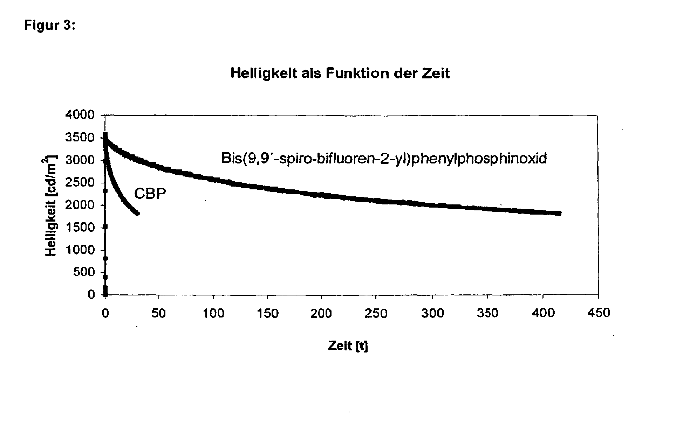

Die beiden Lebensdauerkurven mit BCP und Bis(9,9'-spirobifluoren-2-yl)phenylphosphinoxid, jeweils mit Verwendung einer HBL und einer ETL, wurden zur besseren Vergleichbarkeit in derselben Abbildung dargestellt (Fig. 3). Die Abbildung zeigt den Verlauf der Helligkeit, gemessen in cd/m², mit der Zeit. Als Lebensdauer bezeichnet man die Zeit, nach der 50 % der Anfangsleuchtdichte erreicht werden.

Man erhält bei den gezeigten Helligkeiten für CBP als Wirtsmaterial eine Lebensdauer von ca. 30 h bei einer Anfangshelligkeit von 3500 cd/m², was einer beschleunigten Messung entspricht, da die Anfangshelligkeit deutlich über der Helligkeit liegt, die man für typische Aktiv-Matrix-angesteuerte Display-Anwendungen benötigt.

Für Bis(9,9'-spirobifluoren-2-yl)phenylphosphinoxid erhält man bei derselben Anfangshelligkeit eine Lebensdauer von ca. 400 h, was einer Lebensdauer von etwa 25000 h bei 500 cd/m² und einer Steigerung der Lebensdauer um einen Faktor von mehr als 10 gegenüber OLEDs mit CPB als Matrixmaterial entspricht. Die Lebensdauer ohne Verwendung einer HBL und einer ETL, wenn also die dotierte Matrix in direktem Kontakt zur Kathode steht, ist vergleichbar. Weitere OLEDs mit Bis(9,9'-spirobifluoren-2-yl)sulfoxid (Beispiel 3a und 3b) und 1,1'-Binaphthyl-2,2'-bis(diphenylphosphinoxid) (Beispiel 4a und 4b) als Wirtsmaterial zeigen sowohl mit HBL und ETL als auch ohne HBL und ETL ebenfalls eine verbesserte Lebensdauer im Vergleich zu OLEDs mit CBP (Beispiel 1) als Wirtsmaterial. Alle Beispiele sind in Tabelle 1 zusammengefaßt.

| Experiment | EML | HBL | ETL | Max. Effizienz (cd/A) | Max. Leistungseffizienz (lm/W) | Spannung (V) bei 100cd/m² | Lebensdauer (h) bei 10 mA/cm² |
|---|---|---|---|---|---|---|---|
| Beispiel 1a) Vergleich | CBP:15% Ir(ppy)₃ (20 nm) | BCP 10(nm) | AIQ₃ (10 nm) | 22 | 12 | 4.8 | 30 |
| Beispiel 1b) Vergleich | CBP:15% Ir(ppy)₃ (40 nm) | | | 13 | 7 | 6.1 | 25 |
| Beispiel 2a) | **M1**:15% Ir(ppy)₃ (20 nm) | BCP 10(nm) | AIQ₃ (10 nm) | 42 | 34 | 4.0 | 400 |
| Beispiel 2b) | **M1**:15% Ir(ppy)₃ (40 nm) | | | 42 | 45 | 3.0 | 390 |
| Beispiel 3a) | **M2**:15% Ir(ppy)₃ (20 nm) | BCP 10(nm) | AIQ₃ (10 nm) | 28 | 25 | 4.6 | 180 |
| Beispiel 3b) | **M2**:15% Ir(ppy)₃ (40 nm) | | | 31 | 29 | 3.5 | 150 |
| Beispiel 4a) * | **M3**:15% Ir(ppy)₃ (20 nm) | BCP 10(nm) | AIQ₃ (10 nm) | 25 | 13 | 5.4 | 310 |
| Beispiel 4b) * | **M3**:15% Ir(ppy)₃ (40 nm) | | | 29 | 23 | 4.4 | 280 |

| | | | | | | | |
|---|---|---|---|---|---|---|---|
| Legende: **M1** =Bis(9,9'-spiro-bifluoren-2-yl)-phenylphosphinoxid * (Vergleichsbeispiel) **M2** = Bis(9,9'-spirobifluoren-2-yl)sulfoxid **M3** = 1,1'-Binaphthyl-2,2'-bis(diphenylphosphinoxid) | | | | | | | |

## Patentansprüche

1. Verbindung gemäß Formel (40), (41 a), (42), (43), (44a), (45), (46), (47a) oder (48), 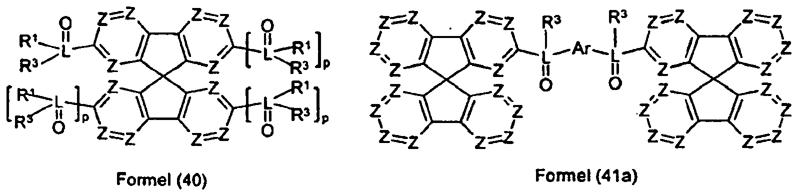 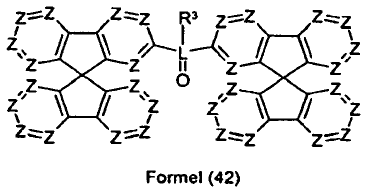 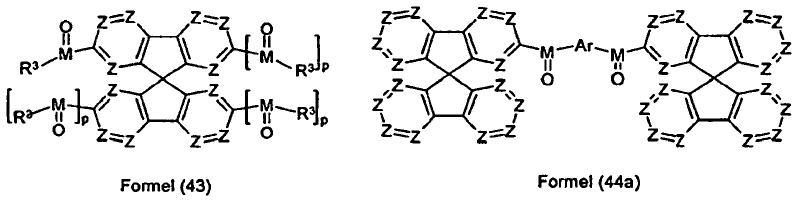 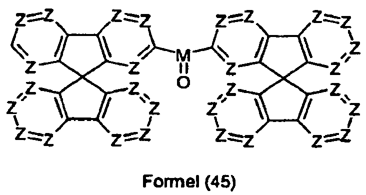 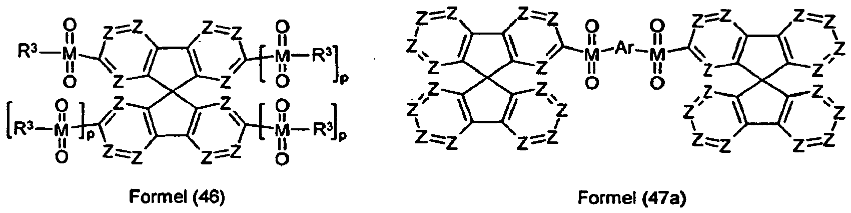 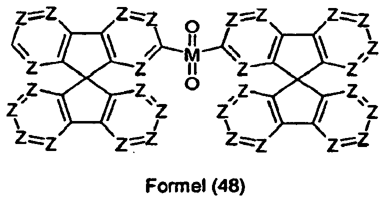 wobei die verwendeten Symbole und Indizes die folgenden Bedeutungen aufweisen:
L ist bei jedem Auftreten P;
M ist bei jedem Auftreten S;
Z ist gleich oder verschieden bei jedem Auftreten CR¹ oder N;
R¹ ist gleich oder verschieden bei jedem Auftreten H, F, Cl, Br, I, CN, NO₂, N(R³)₂, eine geradkettige, verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nicht-aromatische Reste R³ substituiert sein kann, wobei mehrere Substituenten R¹ miteinander ein weiteres mono- oder polycyclisches, aliphatisches oder aromatisches Ringsystem bilden können;
R³ ist gleich oder verschieden bei jedem Auftreten eine geradkettige oder verzweigte oder mono-, oligo- oder polycyclische Alkyl-, Alkoxy- oder Thioalkoxygruppe mit 1 bis 40 C-Atomen, wobei ein oder mehrere nicht benachbarte CH₂-Gruppen durch -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- oder -CONR¹⁰- ersetzt sein können und wobei ein oder mehrere H-Atome durch F, Cl, Br, I, CN, NO₂ ersetzt sein können, oder ein aromatisches oder heteroaromatisches Ringsystem mit 1 bis 40 C-Atomen, wobei ein oder mehrere H-Atome durch F, Cl, Br, I, CN, NO₂ ersetzt sein können und das durch einen oder mehrere, nicht-aromatische Reste R¹ substituiert sein kann, wobei mehrere Substituenten R¹ miteinander ein weiteres mono- oder polycyclisches, aliphatisches oder aromatisches Ringsystem bilden können und wobei R³ mit R¹ und / oder R² ein mono- oder polycyclisches, aliphatisches oder aromatisches Ringsystem bilden kann;
R⁴, R⁵, R⁶, R⁷, R⁸, R⁹, R¹⁰ sind gleich oder verschieden bei jedem Auftreten H oder ein aliphatischer oder aromatischer Kohlenwasserstoffrest mit 1 bis 20 C-Atomen;
p ist bei jedem Auftreten gleich oder verschieden 0 oder 1;
mit der Maßgabe, dass in Formel (43) nicht alle p = 1 sind, wenn Z = CH und M = S ist und wenn R³ für eine substituierte oder unsubstituierte Phenylgruppe steht.

2. Elektronisches Bauteil enthaltend mindestens eine Verbindung gemäß Anspruch 1.

3. Elektronisches Bauteil gemäß Anspruch 2, **dadurch gekennzeichnet, dass** es sich um eine organische Leuchtdiode (OLED), eine organische integrierte Schaltung (O-IC), einen organischen Feld-Effekt-Transistor (OFET), einen organischen Dünnfilmtransistor (OTFT), eine organische Solarzelle (O-SC), einen organischen optischen Detektor, einen organischen Photorezeptor in der Elektrophotographie oder eine organische Laserdiode (O-Laser) handelt.

4. Elektronisches Bauteil gemäß Anspruch 2 oder 3, **dadurch gekennzeichnet, dass** das elektronische Bauteil eine organische Leuchtdiode (OLED) ist, die mindestens eine Lochblockierschicht und/oder mindestens eine Elektronentransportschicht und/oder mindestens eine Elektroneninjektionsschicht und/oder weitere Schichten enthält.

## Claims

1. Compound of the formula (40), (41 a), (42), (43), (44a), (45), (46), (47a) or (48), 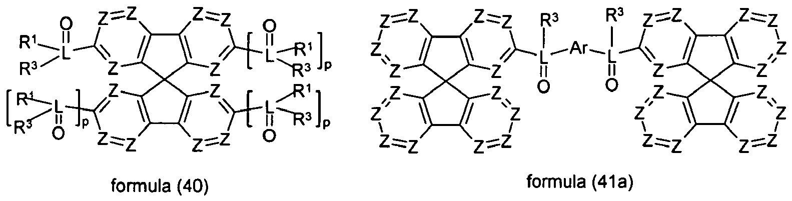 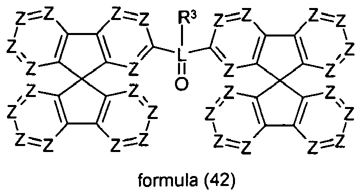 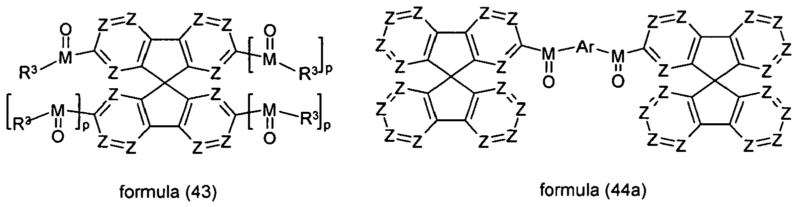 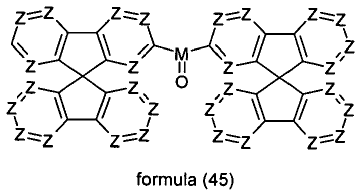 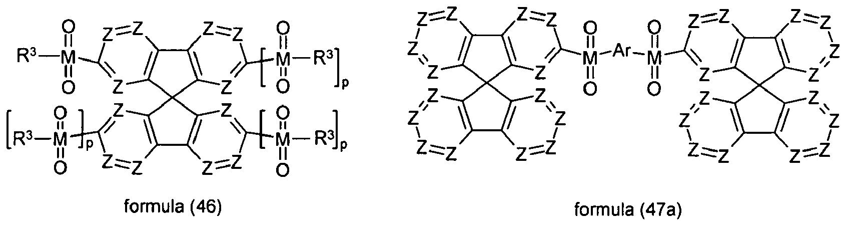 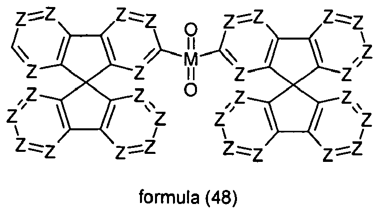 where the symbols and indices used have the following meanings:
L is on each occurrence P;
M is on each occurrence S;
Z is, identically or differently on each occurrence, CR¹ or N;
R¹ is, identically or differently on each occurrence, H, F, Cl, Br, I, CN, NO₂, N(R³)₂, a straight-chain, branched or mono-, oligo- or polycyclic alkyl, alkoxy or thioalkoxy group having 1 to 40 C atoms, where one or more non-adjacent CH₂ groups may be replaced by -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- or -CONR¹⁰- and where one or more H atoms may be replaced by F, Cl, Br, I, CN, NO₂, or an aromatic or heteroaromatic ring system having 1 to 40 C atoms, where one or more H atoms may be replaced by F, Cl, Br, I, CN, NO₂ and which may be substituted by one or more, non-aromatic radicals R³, where a plurality of substituents R¹ may form a further mono- or polycyclic, aliphatic or aromatic ring system with one another;
R³ is, identically or differently on each occurrence, a straight-chain or branched or mono-, oligo- or polycyclic alkyl, alkoxy or thioalkoxy group having 1 to 40 C atoms, where one or more non-adjacent CH₂ groups may be replaced by -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- or -CONR¹⁰- and where one or more H atoms may be replaced by F, Cl, Br, I, CN, NO₂, or an aromatic or heteroaromatic ring system having 1 to 40 C atoms, where one or more H atoms may be replaced by F, Cl, Br, I, CN, NO₂ and which may be substituted by one or more, non-aromatic radicals R¹, where a plurality of substituents R¹ may form a further mono- or polycyclic, aliphatic or aromatic ring system with one another and where R³ may form a mono- or polycyclic, aliphatic or aromatic ring system with R¹ and/or R²;
R⁴, R⁵, R⁶, R⁷, R⁸, R⁹, R¹⁰ are, identically or differently on each occurrence, H or an aliphatic or aromatic hydrocarbon radical having 1 to 20 C atoms;
p is on each occurrence, identically or differently, 0 or 1;
with the proviso that, in formula (43), not all p = 1 if Z = CH and M = S and if R³ stands for a substituted or unsubstituted phenyl group.

2. Electronic component containing at least one compound according to Claim 1.

3. Electronic component according to Claim 2, **characterised in that** it is an organic light-emitting diode (OLED), an organic integrated circuit (O-IC), an organic field-effect transistor (OFET), an organic thin-film transistor (OTFT), an organic solar cell (O-SC), an organic optical detector, an organic photoreceptor in electrophotography or an organic laser diode (O-laser).

4. Electronic component according to Claim 2 or 3, **characterised in that** the electronic component is an organic light-emitting diode (OLED) which comprises at least one hole-blocking layer and/or at least one electron-transport layer and/or at least one electron-injection layer and/or further layers.

## Revendications

1. Composé selon la formule (40), (41 a), (42), (43), (44a), (45), (46), (47a) ou (48) : 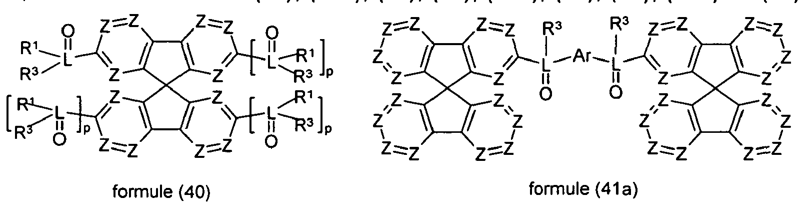 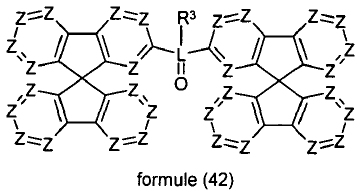 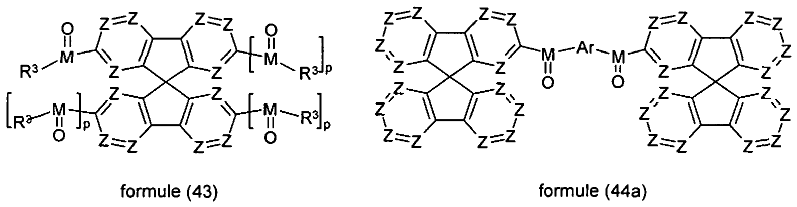 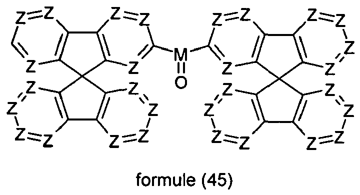 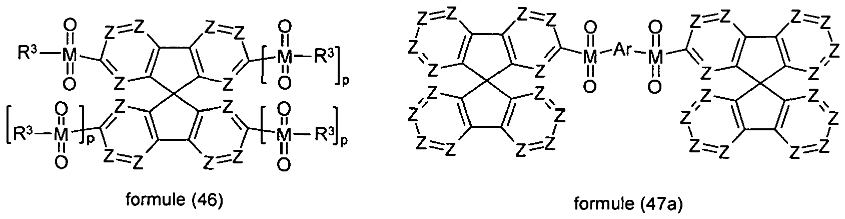 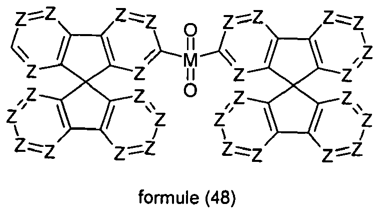 dans lesquelles les symboles et indices utilisés présentent les significations qui suivent:
L est, pour chaque occurrence, P ;
M est, pour chaque occurrence, S ;
Z est, de manière identique ou différente pour chaque occurrence, CR¹ ou N ;
R¹ est, de manière identique ou différente pour chaque occurrence, H, F, CI, Br, I, CN, NO₂, N(R³)₂, un groupe alkyle, alcoxy ou thioalcoxy en chaîne droite, ramifié ou monocyclique, oligocyclique ou polycyclique comportant de 1 à 40 atome(s) de C, où un ou plusieurs groupe(s) CH₂ non adjacents peut/peuvent être remplacé(s) par -R⁴C=CR⁴-, -C=C-, Si(R⁴)₂, Ge(R⁵)₂, Sn(R⁶)₂, NR⁷, C=O, C=S, C=Se, C=NR⁸, -O-, -S-, -NR⁹- ou -CONR¹⁰- et où un ou plusieurs atome(s) de H peut/peuvent être remplacé(s) par F, CI, Br, I, CN, NO₂, ou un système de cycle aromatique ou hétéroaromatique comportant de 1 à 40 atome(s) de C, où un ou plusieurs atome(s) de H peut/peuvent être remplacé(s) par F, CI, Br, I, CN, NO₂ et lequel peut être substitué par un ou plusieurs radical/radicaux non aromatique(s) R³, où une pluralité de substituants R¹ peuvent former un autre système de cycle aliphatique ou aromatique monocyclique ou polycyclique les uns avec les autres ;
R³ est, de manière identique ou différente pour chaque occurrence, un groupe alkyle, alcoxy ou thioalcoxy en chaîne droite ou ramifié ou monocyclique, oligocyclique ou polycyclique comportant de 1 à 40 atome(s) de C, où un ou plusieurs groupe(s) CH₂ non adjacents peut/peuvent être remplacé(s) par -R⁴C=CR⁴-, -C≡C-, Si(R⁴)₂, Ge(R⁵)₂, Sn(R⁶)₂, NR⁷, C=O, C=S, C=Se, C=NR⁸, -O-, -S-, -NR⁹- ou -CONR¹⁰- et où un ou plusieurs atome(s) de H peut/peuvent être remplacé(s) par F, CI, Br, I, CN, NO₂, ou un système de cycle aromatique ou hétéroaromatique comportant de 1 à 40 atome(s) de C, où un ou plusieurs atome(s) de H peut/peuvent être remplacé(s) par F, CI, Br, I, CN, NO₂ et lequel peut être substitué par un ou plusieurs radical/radicaux non aromatique(s) R¹, où une pluralité de substituants R¹ peuvent former un autre système de cycle aliphatique ou aromatique monocyclique ou polycyclique les uns avec les autres et où R³ peut former un système de cycle aliphatique ou aromatique monocyclique ou polycyclique avec R¹ et/ou R² ;
R⁴, R⁵, R⁶, R⁷, R⁸, R⁹, R¹⁰ sont, de manière identique ou différente pour chaque occurrence, H ou un radical hydrocarbone aliphatique ou aromatique comportant de 1 à 20 atome(s) de C ;
p est, pour chaque occurrence, de manière identique ou différente, 0 ou 1 ;
étant entendu que, dans la formule (43), tous les p ne sont pas égaux à 1 si Z = CH et M = S et si R³ représente un groupe phényle substitué ou non substitué.

2. Composant électronique contenant au moins un composé selon la revendication 1.

3. Composant électronique selon la revendication 2, **caractérisé en ce qu'**il s'agit d'une diode émettrice de lumière organique (OLED), d'un circuit intégré organique (O-IC), d'un transistor à effet de champ organique (OFET), d'un transistor à film mince organique (OTFT), d'une cellule solaire organique (O-SC), d'un détecteur optique organique, d'un photorécepteur organique en électrophotographie ou d'une diode laser organique (O-laser).

4. Composant électronique selon la revendication 2 ou 3, **caractérisé en ce que** le composant électronique est une diode émettrice de lumière organique (OLED) qui comprend au moins une couche de blocage de trous et/ou au moins une couche de transport d'électrons et/ou au moins une couche d'injection d'électrons et/ou d'autres couches.
